(19) **Europäisches Patentamt**

**European Patent Office**

**Office européen des brevets**

(11) **EP 1 276 031 B1**

(12) **EUROPEAN PATENT SPECIFICATION**

(45) Date of publication and mention
of the grant of the patent:
**29.09.2004 Bulletin 2004/40**

(51) Int Cl.⁷: **G05D 7/01**, C23C 16/455

(21) Application number: **02254962.0**

(22) Date of filing: **15.07.2002**

(54) **Gas delivery metering tube**

Dosierrohr für Gasabgabe

Tube doseur pour la fourniture de gaz

(84) Designated Contracting States:
**DE FR GB IT NL**

(30) Priority: **13.07.2001 US 905349**

(43) Date of publication of application:
**15.01.2003 Bulletin 2003/03**

(73) Proprietor: **ASML US, Inc.**
**Scotts Valley, CA 95066 (US)**

(72) Inventors:
• **DeDontney, Jay Brian**
**Prunedale, CA 93907 (US)**

• **DeSa, Anthony**
**Anaheim, CA 92082 (US)**
• **Kurita, Samuel**
**Scotts Valley, CA 95066 (US)**

(74) Representative: **Stoner, Gerard Patrick et al**
**Mewburn Ellis LLP**
**York House**
**23 Kingsway**
**London WC2B 6HP (GB)**

(56) References cited:
**EP-A- 1 054 076**     **WO-A-99/04059**
**US-A- 4 854 266**     **US-A- 6 146 461**

EP 1 276 031 B1

**Description**

This invention relates generally to a gas delivery metering tube for the delivery of gases. More particularly, the invention relates to nested axially aligned or co-axial gas delivery metering tubes that promote substantially uniform distribution of gases.

BACKGROUND

The delivery of gases is an important aspect in a great variety of industries. For example, in the field of semiconductor processing or manufacturing, the delivery of gases plays a critical role. One type of semiconductor processing is chemical vapor deposition. Chemical vapor deposition occurs when a stable compound is formed by a thermal reaction or decomposition of certain gaseous chemicals and such compounds are deposited on a surface of a substrate. Chemical vapor deposition systems come in many forms. One apparatus for such a process comprises a conveyorized atmospheric pressure CVD (APCVD) system which is described in U.S. Patent 4,834,020 and is owned by assignee, and is incorporated herein by reference. Other types of CVD apparatus may be used, such as plasma-enhanced CVD (PECVD) systems, and low pressure CVD (LPCVD) systems.

Important components of a semiconductor processing system include a deposition chamber where deposition occurs, and the injector utilized for delivering gaseous chemicals to the surface of the substrate in the deposition chamber. The gases must be distributed over the substrate, so that the gases react and deposit an acceptable film at the surface of the substrate. The deposition chamber must be carefully designed to provide a controlled environment in which deposition can take place. For example, the chamber must provide gas confinement, but reduce re-circulation of the gases which can cause pre reaction of the gases and the deposition of a non-uniform film. The chamber must provide exhaust means for the elimination of excess reactants and reaction by-products, yet not disrupt the flow of gases to the substrate for reaction. Moreover, the temperature of the chamber and its components must be carefully controlled to avoid condensation of reactant gases, minimize accumulation of byproduct dust, and enable cleaning of the system. Additionally, the deposition chamber should preferably maintain mechanical integrity (such as tolerances) throughout its operation. All of these factors must be carefully balanced to provide a proper environment for deposition.

A function of the injector in such a deposition chamber is to distribute the gases to a desired location in a controlled manner. Controlled distribution of the gases maximizes the chance of efficient, homogeneous gas phase reactions, in part by minimizing pre-mixing and prior reaction of the gases. This promotes production of the proper chemical species that will result in a high quality film on the substrate. Controlled gas distribution is needed to make sure the entire film is of a uniform composition. A complete reaction provides a greater opportunity for a good quality film. If the gas flow is uncontrolled, the chemical reaction will not be optimal and the result will likely be a film which is not of uniform composition. When the film is not of uniform composition, proper functioning of the semiconductor is impaired. Thus, it is important that an injector design facilitates the desired flow of the gases in a controlled manner.

Gases may be distributed in other areas of the chamber and/or by components in addition to the injector. For example, inert gases may be conveyed to the chamber to separate and/or direct deposition gases in a desired manner. Inert and other gases may be delivered to the chamber to function as dilution and carrier gases. One such example of the use of gases in such a manner is found in co-pending US patent application Serial Number 09/185,180, the entire disclosure of which is hereby incorporated by reference.

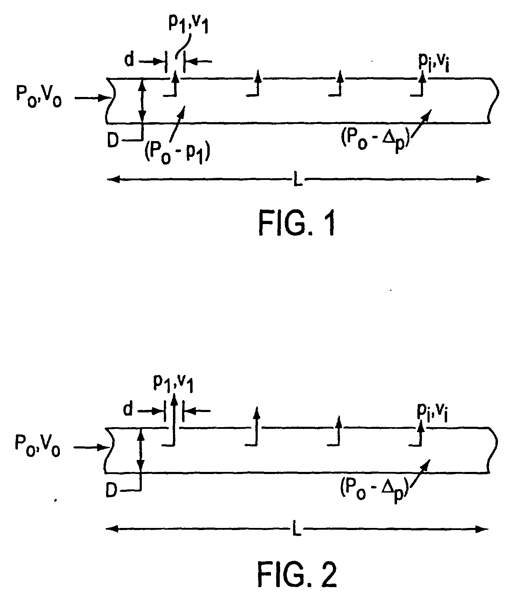

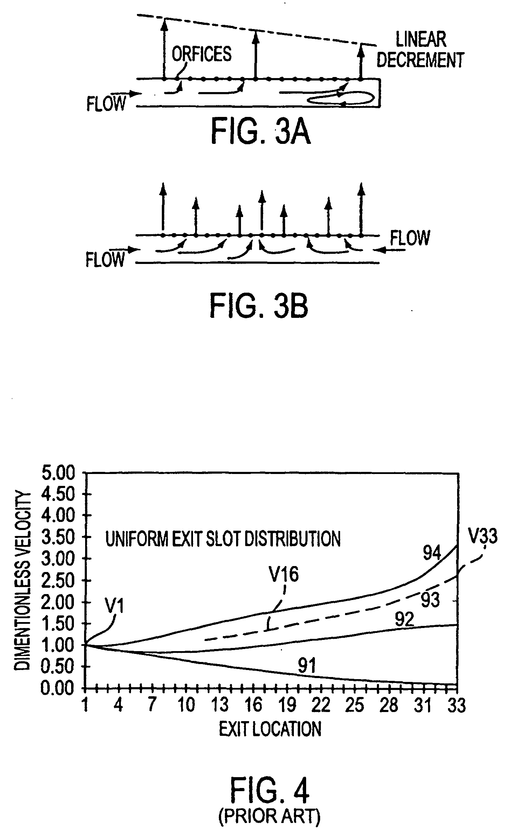

In the field of semiconductor fabrications, with device geometries shrinking to <0.2 $\mu$m (micrometers) comes the increasing demand for film deposition thickness nonuniformities of <2% range. The prior art for linear gas distribution systems has not been entirely successful in meeting these greater requirements. The simplest prior art design is a single tube with a distribution of holes or orifices along its surface as shown in Fig. 1, and as seen e.g. in US-A-4 854 266, having a tube length of L and a diameter of D, with multiple orifices having diameter d. Gas is introduced at one end of the tube at a pressure $P_o$ and an initial velocity $V_o$. In this design, uniformity will typically be dependent on pressure. At each orifice, pressure and flow are reduced by some amount. Assuming the orifice sizes are small compared to the tube diameter D, and the supply pressure is adequately large, then the pressure and flow reduction per orifice are small compared to $P_o$ and $V_o$. Reduction in velocity along the tube is typically accompanied by an increase in pressure, except for small gas flows. At some distance far from the gas supply, the pressure in the tube $P_o$ will have dropped (as expressed by: $P_o - \Delta p$). With a single metering tube having orifices of the same diameter and equally spaced, uniform gas flow is not achieved. A particular shortcoming of the single tube prior art is the difficulty of providing good uniformity over increasing lengths needed to accommodate larger substrate sizes or diameters. For certain pressures, a given dimensional relationship between D, d, and L will result in somewhat uniform velocity vectors ($v_i$) and uniform gas flow by either redistributing these orifices of same given diameter or by varying the diameters of equally spaced holes. However, this distribution of orifices will result in optimum flow for a narrow range of operating conditions, if not for just one particular operating condition. Moreover, such prior art designs typically produce films having a high thickness nonuniformity of about 5 to 10%, depending upon the gas flow and pressure. Additionally, at low gas flows and low pressures, a higher flow of gas will emerge from the end nearest the supply as illustrated in Fig. 2. In other words, if $P_o$ is a relatively low value, the overall pressure in the tube drops more quickly as a function of the distance from the gas supply. The overall flow uniformity in this case will be very poor. In addition, gas flow from such tubes will tend toward increased directionality ( also referred to as "jetting") as the supply flow and pressure increase. The gas flow out of the tube is nonuniform and exhibits linear decrement across its length as shown in Fig. 3a. Alternatively, gas may be introduced at each end of the tube as shown in Fig. 3b. In both cases the gas flow is not distributed uniformly which results in non-uniform deposition across the wafer.

An alternative prior art approach is the use of a single tube of porous material. Again, gas is introduced at one end of the tube. With this approach the "jetting" issue that accompanies a tube with holes is minimized. The porosity of the material will typically determine the achievable back pressure within the tube, and hence also the overall uniformity along the length of the tube. For example, a screen mesh may be considered a porous material. For best uniformity, the mesh must offer good resistance to gas flow to maintain good backing pressure along the full length of the tube. Typically resistance to flow depends on the overall open area to tube surface area. Mesh openings are typically of the order of the thickness of the material or larger (> 0.005 inches). A second example is a porous ceramic having particle spacings on the order of micrometers (such materials are used often in filtration devices) and thicknesses on the order of millimeters. Such materials could offer resistance to gas flow to enable build up of uniform backing pressure, and good uniformity of delivered gas along the full length of the delivery line.

Though porous ceramic tubes can provide good uniformity of gas delivery, the material itself is quite fragile, and seals to the gas supply lines that can also withstand a wide range of temperatures are difficult to make.

A third alternative is to taper the tube diameter as a function of distance from the supply so that the fluid velocity is kept constant while the mass rate of flow decreases. The main drawback to this approach is that a design optimized for uniform flow at one flow rate will not work correctly at another flow rate.

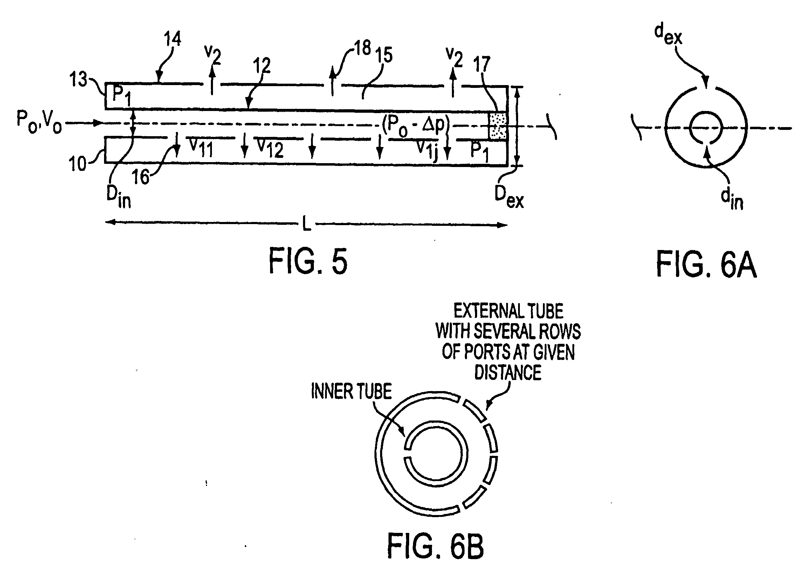

The biggest weakness of known designs using single perforated or porous tubes is that they show relatively high sensitivity to changes in pressure, resulting in nonuniform flow as a function of position along the length of the delivery tube. Further, as shown in Fig. 4, non-uniform flow is a strong function of the gas flowrate, and as different applications and process conditions call for different gas flow rates, it becomes increasingly complicated to design and develop processes that provide uniform film deposition. The plots illustrated in Figure 4 represent a range of gas flow conditions and geometries typical of CVD applications, having Reynolds numbers $100<R_e<2000$. Moreover, as wafer diameters increase, the film non-uniformities are often exacerbated with increasing length of the gas delivery tube.

Changes in pressure may be imposed deliberately by a user, but often times occur due to fluctuations in the facilities gas delivery system to the CVD system. Thus, with the prior art, changes in gas pressure will influence the uniformity of gas delivery within the injector and/or deposition chamber, which then influences the resulting film uniformity or composition on the substrates. In other words, with prior art systems the gas delivery apparatus may be useful for only one operating condition. Accordingly, it is desirable to provide a gas delivery system that promotes substantially uniform flow and/or distribution of gases, particularly along a length which is impervious to fluctuations in the delivery system, and over a wide operational range of gas flows.

In one aspect the present invention provides a gas delivery metering tube for delivering a gas, comprising:

an outer tube having an open inlet end and a closed end, and an array of orifices formed in said outer tube and extending along the substantial length thereof;
an inner tube having an open inlet end, said inner tube being nested and axially aligned inside said outer tube forming an effective annular space between said tubes,

characterised in that the inner tube has an open outlet end which terminates short of the closed end of the outer tube, and in that a gas flow divider construction adjacent the inlet ends of the inner and outer tubes provides a first gas flow path coupled to said inner tube and a second gas flow path coupled to the annular space between the inner and outer tubes.

Preferred features are set out in the sub-claims.

A further aspect (claim 9) is chemical vapour deposition system comprising such a gas delivery metering tube.

A further aspect (claim 12) is the use of such a tube in chemical vapour deposition, to deliver gas to a deposition chamber.

Other objects and advantages of the invention become apparent upon reading of the detailed description of the invention and the appended claims provided below, and upon reference to the drawings, in which:

Figure 1 is a cross-sectional view of gas flows in a single tube used in the prior art.
Figure 2 is a cross-sectional view of gas flows in a single tube used in the prior art when the pressure is low.
Figure 3a and 3b are schematic representations of the gas flow non-uniformities of the prior art.
Figure 4 is a graph illustrating the gas flow distribution along the length of various types of tubes (prior art).

Figure 5 is a cross-sectional view of the gas delivery tube of the present invention.

Figures 6a and 6b are cross-sectional end views of the gas delivery tube according to two embodiments of the present invention.

Figure 7 is a cross sectional view of one example of a CVD deposition chamber showing a protective shield and an injector which may employ the gas delivery tube of the present invention.

Figure 8 is a cross sectional view of one example of an injector which may employ the gas delivery tube of the present invention.

Figure 9 is an exploded view of another embodiment of the gas metering tube of the present invention.

Figure 10 is a partial side view showing both ends of one example of the gas metering tube of the present invention.

Figures 11a, 11b, and 11c are partial cross sectional views of the ends of one example of the gas metering tube of the present invention with detail views of the internal construction at each end of the tube.

Figures 12a and 12b show cross sectional side and end views, respectively, of one example of a gas flow divider used in the gas metering tube of the present invention.

Figures 13a and 13b show cross sectional side and end views, respectively, of one example of a spacer or standoff used in the gas metering tube of the present invention.

Figures 14a and 14b are perspective and side cross sectional views, respectively, of one example of a gas supply port which may be employed with the gas metering tube of the present invention.

DETAILED DESCRIPTION

We find that using constructions of the kind described, one can meter the gas distribution along a length, in particular the length of the tube, and make the resulting gas distribution from the tube less sensitive to pressure changes over a wide range of operating conditions or gas flow ranges.

Typically there is a gas delivery tube having a tube assembly of two or more nested, axially aligned or coaxial tubes with the innermost tube preferably attached to a gas supply, and with both the inner and outer tubes having one or more arrays of orifices distributed along the lengths of the innermost and outermost tubes. For purposes of discussion, a gas delivery tube 10 comprised of two axially aligned, nested tubes having circular cross section shall be discussed, however other numbers of tubes can be used such as three nested or more coaxial tubes. The length of gas delivery tube to be used to process semiconductor substrates is typically several centimeters longer than the width or diameter of the substrate.

One embodiment of the invention is shown with reference Figures 5 and 6a. Figure 5 is a schematic drawing of a gas delivery tube 10 comprised of a two tube assembly having coaxial inner 12 and outer 14 tubes separated by an annular space 15. Each tube has two ends. The inner tube 12 has one end 13 attached to the gas supply and the other end 17 is capped. One or more arrays of orifices 16 are distributed along the substantial length of the inner tube 12, and are positioned and sized to establish a uniform backing pressure along the full length of the inner tube 12, and still provide sufficient gas flow out of the inner tube 12 into the annular space 15. The outer tube 14 contains an array of orifices 18 distributed along its substantial length. The one or more arrays of orifices 18 are positioned and sized to maintain a uniform backing pressure within the annular space, and to provide uniform gas flow out of the outer tube 14 and into the area adjacent the outer tube 14. Preferably, the outer tube 14 is capped at both ends; however, in an alternative embodiment the outer tube may also receive a gas supply. Preferably, the line of inner orifices 16 are rotationally offset 180 degrees from the line array of outer orifices 18 as shown in Figure 5 and 6a. However, any rotational alignment and liner alignment between these arrays can be used. The preferred embodiment aligns the inner array of orifices 180° from the outer array of orifices.

While the gas delivery tube 10 has been described having two axially aligned nested tubes, additional tubes may be used. For example, the gas delivery tube 10 may be comprised of three, or more, coaxial tubes. Through the use of two or more nested coaxial tubes, the inventive apparatus reduces the sensitivity to pressure effects over a wide flow range by first establishing uniform backing pressure along the length of the inner tube, and then maintaining and transferring that uniformity and constancy of pressure to the annular space between the two tubes over the full length of the tube assembly 10. The resulting gas outflow from the outer tube can thus be quite uniform. The present invention thus effectively separates the establishment of pressure and flow over the length of the tube assembly into two steps.

As discussed above, the prior art having a single tube with an array of orifices and supplied by gas at one end requires that the gas backing pressure be equivalent over its full length to provide uniform flow out of the array of orifices. At low flow conditions, the backing pressure may fall too low, and flows from orifices furthest from the supply may drop resulting in nonuniform distribution over the length of the tube. In contrast, in the proposed construction the inner tube 12 can be sized in diameter and the array of orifices 16 to establish uniform backing pressure along its full length In other words, the relationship between the diameter of the tube and the diameter of the orifices is important. The orifices 16 are distributed along the substantial length, and preferably the full length, of the inner tube 12 and are sized and numbered to ensure sufficient resistance to gas flow outward from the inner tube to build backing pressure within the whole inner tube's length. Gas flow from the inner tube is evenly distributed along its length, and feeds the annular space between the inner and outer tubes.

In Mokhtari et al. ("*Flow Uniformity and Pressure Variation in Multi-Outlet Flow Distribution Pipes*," Advances in Analytical, Experimental and Computational Technologies in Fluids, Structures, Transients and Natural hazards, ASME, PVP - Volume 355, page 113, 1997) the general relationships among the inner diameter of the inner tube 12 ($D_{in}$), tube length L, and orifice size ($d_{in}$) for establishing uniform flow along a single tube, are discussed. Further, in Acrivos et al. ("*Flow Distribution in Manifolds*," Chemical Engineering Science, Vol. 10, pages 112 to 124, Pergamon Press 1959) requires that $L/D_{in} < 70$ while Mokhtari suggests by example that $L/D_{in} > 50$. In addition, Mokhtari et al show that $D_{in}/d_{in} \approx 10$ or more should expect to provide good flow uniformity over the full length of the tube. Acrivos suggests that the ratio of total orifice area ($N\pi d_{in}^2/4$) to area of the manifold ($\pi D_{in}^2/4$) should not exceed unity.

The prior art thus provide a set of rules to establish relatively stable backing pressure in a single tube. Specifically, the following relationships are shown: $L/D < 70$, $D/d \approx > 10$, and $Na_{port}/A_{tube} \approx 1$, where N is the number of orifices in the tube, and $a_{port}$ is the cross sectional area of each of these orifices. This prior art is limited to a single tube arrangement, however, and as discussed above such single tube arrangements are limited in their performance and do not provide satisfactory film uniformity.

The inventors have discovered that maintaining the prior art requirements for the inner tube 12 establishes relatively stable backing pressure ($P_o - \Delta p$) within the inner tube 12. Further, the inventors have discovered that maintaining substantially constant gas flow from the orifices 16 of the inner tube feeds into the annular space 15 between the two tubes, and provides substantially uniform gas flow over the full length of tubes. According to the present invention, the pressure uniformity in the annular space between the inner 12 and outer 14 tubes is established by the size of the annular space, and the uniformity of the gas distribution is governed by the distribution of the orifices 16 of the inner tube 12, but is substantially improved by the addition of an outer tube 14 and its orifices 18. Thus, according to the present invention the combination of at least two coaxial tubes establishes constant and uniform pressure within the annular space 15 between the innermost 12 and outermost 14 tubes and along the length of such tubes, resulting in distribution of gases from the outermost tube that can be very uniform.

The inventors have found that preferably the cross-sectional area of the annular space 15 between the inner 12 and outer 14 tubes to that of the inner tube 12 cross-sectional area should be approximately equivalent, but must be at least within a factor of three of each other. In other words, the effective diameter of the effective annular space $D_{eff}$, and the inner diameter of the innermost tube $D_{in}$ are within a factor of three of each other, and preferably $D_{eff} \approx D_{in}$. In addition, the ratio of inner surface area of a tube to the total cross-sectional area of all of the orifices in the tube should be equal to or greater than approximately 10 and preferably greater than 100: In other words, $SurfaceArea_{outer}/NA_{outer} \approx 10$ or more. This provides significantly improved gas flow non-uniformity values, i.e. equal to and less than about 3% range for the present invention as compared to about 5 to 10% obtained by the prior art. The sensitivity of the relationship between gas flow uniformity to the tube length is much less for the outer tube 14 than it is for the inner tube 12.

In summary, the inventive idea is to establish constant backing pressure along the length of the gas delivery tube through the design of the inner tube, and then to maintain a constant pressure and uniform distribution over the length through the geometric relationship of the inner and outer tubes, and finally to meter the gas flow through the outer tube's orifice distribution.

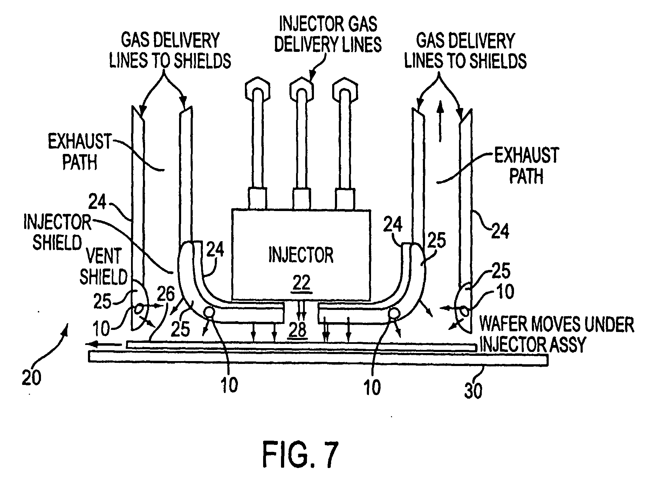

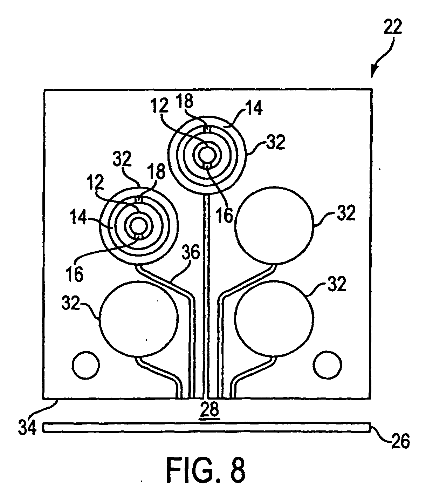

The present invention may be used in a vast number of applications. Two such applications are discussed below. In one embodiment, the gas delivery metering tube 10 of the present invention is employed with an atmospheric/subatmospheric chemical vapor deposition system using a linear injector arrangement, such as that illustrated in Figs. 7 or 8. The gas delivery metering tube 10 may be used within the injector itself (as shown in Figure 8) and/or within shields that flank the injector (as illustrated in Figure 7).

A portion of a CVD system 20 is shown in Fig. 7. The CVD system 20 includes a deposition chamber including an injector 22, protective shield assembly 24 and a wafer 26 which is transported by a transport mechanism 30 such as a belt underneath the injector 22 and shield assembly 24 and through a deposition region 28. Gases are injected into the deposition region 28 from the injector and react to deposit a layer or film on the surface of the wafer. The shield assembly 24 typically injects an inert gas, such as nitrogen, which aids in minimizing the build up of deposits on the injector surfaces and also acts to help isolate the deposition region 28. In this embodiment, the shield assembly 24 is comprised of four sections, two of which flank the injector 22. An example of this type of CVD system is further described in US Patent No. 5,849,088, and patent application Serial No. 09/185,180 (Attorney Docket No A-65583-1); the disclosures of both are hereby incorporated by reference in their entirety.

With industry requirements for film thickness non-uniformities of less than about 3% range, it is important for the shield gas flow flanking the injector to remain stable over time, and that gas flow on each side of the injector be well-defined along its own length and also be well-defined with respect to the gas flow on the side opposite the injector. Deposition gases are delivered perpendicularly onto a substrate's surface by the linear injector, with gases exhausted to either side of the injector. More specifically, the shield assembly's 24 primary purpose is to minimize deposition of unused material on the injector 22 and exhaust path surfaces. The shield assembly 24 consists of several sections with contoured surfaces of perforated material forming a plenum 25 therein through which an inert gas is delivered. The inert gas is delivered into the exhaust path and dilutes the unused deposition gas stream and also directs the unused deposition gases away from the exhaust path surfaces.

For maximum effectiveness, the inert gas must be delivered just downstream of the deposition area, and this proximity requires that the inert gas not perturb the distribution of deposition gases onto the wafer substrate. In addition, typical APCVD and SACVD tools require application of heat at the substrate to enable the deposition gases to react and recombine to form the desired films. The wafer temperature is typically 500°C or more, and thus the surrounding apparatus, though not directly heated, can also expected to be at elevated temperatures (several hundreds of degrees C). Thus, it is preferred for the inert gas to be metered and delivered at uniformities along the length of the shield and the injector which are similar to the uniformities required of the deposition gases ( i.e. about< 1%nonuniformity), and its hardware design must be capable of operation over a wide range of temperatures. Of particular advantage, the gas delivery tube 10 of the present invention is well suited for providing such metered gas flow over the full width of the shield assembly which spans the diameters or widths of the substrate, and this is particularly advantageous for large substrate diameter, such as 300 mm wafer. In particular, as shown in Fig. 7, a gas delivery tube 10 of the present invention may be located in the plenum 25 of one or more of the shield assembly sections. The gas delivery tube 10 may be positioned at any desired location within the shield assembly section, and more than one tube may be placed within each section.

Typically, the shield 24 and injector 22 are removed for cleaning with etchants such as hydrofluoric acid. Thus, it is preferable that the gas delivery tube 10 also tolerate such cleaning solutions and/or be easily removable to enable servicing of the shield assembly alone.

In another embodiment, the gas delivery tube 10 may be employed within the injector assembly 22 itself, preferably within a linear injector such as the type described in Patent No. 5,683,516 and patent application Serial no. 09/113,823 (Attorney Docket A-59471-4), the disclosures of which are both hereby incorporated by reference in their entirety. In general, the injector 22 consists of multiple cross channels, or ports 32, running the length of the injector 22, each of which are coupled to common gas delivery surface 34 by narrow slot like channels 36 , which also extend the length of the injector 22. Gases exit the gas delivery surface 34 to the deposition region 28, (i.e. a volume) just above the wafer substrate 26. Preferably, the deposition gases are fed separately to each of the ports 32. The cited disclosures discuss in detail several configurations to ensure uniform distribution of the deposition gases along the full length of the injector 22. Of particular advantage the gas delivery tube 10 of the present invention is well suited as a gas delivery device that may be inserted into one or more of the channels 32 of the injector 22 to provide desired uniform and/or metered gas flow.

Typically non-uniformities of the film thickness using the prior art are close to about 2% range, although this may vary upwards of 4% to 5% film thickness non-uniformity depending on the type of process chemistries used and the CVD conditions. We find that we can improve on the prior art through further improvement of the uniformity of gas distribution, e.g. with film nonuniformities of equal to and less than about 2% range demonstrated, a substantial improvement over the prior art.

Of particular advantage, the present invention may have means to "meter" the gas flow to ensure substantially uniform distribution over the length of the gas delivery system. For the shield application, the gas flow rates are typically on the order of a few standard liters per minute (slm) to about 30 slm per tube, while for the injector application the gas flow rates are preferably on the order of a few slm to about 20 slm. In the shield application, the inert gas is delivered into a relatively unconfined volume behind the shield screen, while in the injector application, the cross proximity of the plenum and channel slot help to modulate the gas distribution and to direct the flow.

The geometry of the linear injector, shield and substrate arrangement requires that gas be introduced at one end of the delivery tube. Prior art for linear gas distribution systems includes several approaches that have not been successful in certain APCVD systems, particularly those for substrates that are ≥200 mm wide. The simplest type of design is a single tube with a distribution of orifices along its surface as shown in Figures 1 and 2 and discussed above.

For the case where the gas delivery metering tube of the present invention is used in the shield application, it is undesirable for the gas flow to "jet" from the inert gas delivery assembly, but rather should emerge azimuthally uniformly from the tube. For this case, according to an alternative embodiment of the present invention, the outer tube orifice distribution pattern may be several arrays or rows of small holes along the length of the tube and azimuthally distributed (Figure 6b).

For the case of the injector application illustrated in Fig. 8, the injector cross channel or port itself forms a boundary around the inventive assembly and can modulate the gas direction before it flows through the slot channels to the mixing chamber. Hence, the rules governing the outer tube orifice distribution pattern may be less restrictive in the injector application than that of the shield application, and may consist of a few rows and perhaps longer pitch along the tube length. Utilizing a gas delivery metering tube as disclosed here can promote greater uniform gas flow in both the shield and injector applications. While two specific examples have been discussed, it should be understood that the gas delivery metering tube of the present invention may be employed alone and additionally is suitable in many applications where substantially uniform gas delivery is desirable, such as for example in all CVD applications, semiconductor equipment and the like.

EXPERIMENTAL

Several examples are provided below for illustration purposes only, and are not intended to limit the invention. The parameters of the various examples are shown in Table 1:

Table 1

| | Inner Tube | | | | | Outer tube | | | | |
|---|---|---|---|---|---|---|---|---|---|---|
| Case | # rows | # holes per row | hole dia | ID | OD | # rows | # holes per row | hole dia | ID | OD |
| A | 1@ 2@ | 39 38 | 0.014 | 0.114 | 0.134 | 5 | 156 | 0.014 | 0.186 | 0.25 |
| B | 1 | 39 | 0.010 | 0.114 | 0.134 | 6 | 156 | 0.014 | 0.186 | 0.25 |
| C | porous | | | | | | | | | |
| D | 1 | 39 | 0.0095 | 0.136 | 0.156 | 1 | 77 | 0.0138 | 0.261 | 0.281 |
| E | 1 | 39 | 0.0095 | 0.136 | 0.156 | | 3 | 3.06 x .005 | 0.261 | 0.281 |

Illustrative Examples:

Example 1: The following demonstrates the viability of the design parameters shown in Case A of Table 1, used for a metering tube placed within a protective shield similar to that illustrated in Figure 7.
Backing pressure is approximately 200Torr
Gas Flow: 5 to 30 l/min per tube
Inner tube length (first hole to last hole) = 9.26 inches
Outer tube length (first hole to last hole) = 9.7 inches
The inner tube dimensions are shown in Table 1 (inner diameter, ID, equal to 0.114 inch, and outer diameter, OD, equal to 0.134 inch), while the outer tube dimensions are ID = 0.186 inch and OD = 0.250 inch.
The effective diameter, $D_{eff}$, for the annulus between inner and outer tubes can be determined by:

$$A_{outer} - A_{inner} = \pi \left( \frac{D_{eff}}{2} \right)^2 \tag{1}$$

$$2 \left( \frac{A_{outer} - A_{inner}}{\pi} \right)^{\frac{1}{2}} = D_{eff} \tag{2}$$

$$2 (R_{outer}^2 - R_{inner}^2)^{\frac{1}{2}} = D_{eff} \tag{3}$$

where $A_{outer}$ is the cross-sectional area of the outer tube, $A_{inner}$ is the cross sectional area of the inner tube, having diameters $ID_{outer}$ and $OD_{inner}$, respectively, and $D_{eff}$ is the effective diameter of the annulus between the inner and outer tubes. Thus, solving Equation 3 for the conditions provided above yields:

$$= 2 \times [(.186/2)^2 - (.13412)^2]^{1/2} = \underline{0.129 \text{ inches}} = D_{eff}$$

Of interest is a comparison between the cross sectional area of the tube and the sum of the cross sectional areas of the tube's orifices. For the inner tube, the cross sectional area is $\pi(ID_{inner}/2)^2 = \pi(.114/2)^2 = \underline{0.00325\pi}$, while each orifice's cross sectional area is $\pi(.007)^2 = \underline{0.000049\pi}$.

For the inner tube design we are interested in the value of three conditions as described in the prior art of Mohktari and Acrivos. The three conditions are (a) the ratio of the length of the tube to its diameter, (b) the ratio of the diameter of the tube to the port diameter, and (c) the ratio of the sum of all the orifice areas to the cross sectional area of the tube. Specifically:

$$L/D < 70 \qquad (4a)$$

$$D/d \approx > 10 \qquad (4b)$$

$$NA_{port}/A_{tube} \approx \leq 1 \qquad (4c)$$

The values calculated above for the inner tube design in Case A of the Table 1 yield:

(a) Inner tube L/D = 9.26/0.114 = <u>81</u>
(b) Inner tube D/d = 0.114/0.014 = <u>8.1</u>
(c) The ratio of total number of orifices to cross sectional area inner tube:

$$39 \times (0.000049)\pi/(0.00325\pi) = \underline{0.6}$$

Comparing the calculated values of the proposed design with the design guidelines of the prior art (Equations 4a, 4b, 4c) show that the proposed design for the inner tube of Case A approximately meets the conditions for uniform flow, and it is noted that the design results are on the high side of Condition 4a.

According to the present invention, the design criteria for the outer tube are:

$$D_{eff} \approx D_{in} \text{ (or at least within a factor of 3 of each other)} \qquad (5a)$$

$$\text{Surface Area}_{outer}/NA_{outer} = 10 \text{ or more} \qquad (5b)$$

where $D_{in}$ is the inner diameter of the innermost tube, SurfaceArea$_{outer}$ is the surface area of the outermost tube and NA$_{outer}$ is the total cross sectional area of all the orifices in the outermost tube.

The design values of Case A of Table 1 for the outer tube yield:

(a) $D_{eff}$ = 0.129 ≈ 0.114 = $D_{in}$
(b) Surface area to cross sectional port area = $(9.7)\pi(.186)/(156 \times 5 \times .007^2\pi)$ = 47 and the design criteria are thus met.

Example 2: The following demonstrates the viability of the design parameters shown in Case D of Table 1, used for a metering tube within an injector assembly (as illustrated in Figure 7).

Backing pressure is approximately 200 Torr.
Gas flow: 2 to 20 l/min per tube.
Inner tube length (first hole to last hole) = 9.27 inches
The inner tube and outer tube inner/outer diameter dimensions are given in Case D of Table 1. The various key design values can be calculated using the equations and process described in Example 1 above. Specifically,

$$D_{eff} \text{ for annulus between Inner and Outer tubes}$$

$$= 2 \times [(.261/2)^2 - (.156/2)^2]^{1/2} = \underline{0.209 \text{ inches}} = Deff$$

$$\text{Cross sectional area of inner tube} = \pi(.136/2)^2 = \underline{0.00462\pi}$$

$$\text{Cross sectional area of inner and outer orifices} = \pi(.0048)^2 = \underline{0.000023\pi}$$

Using this data, the relationships shown in 4a, 4b, 4c for the inner tube design of Case D may be computed as:

$$L/D_{in} = 9.27/.136 = \underline{68}$$

$$D_{in}/d = .136/.0095 = \underline{14.3}$$

$$Na_{port}/A_{tube} = 39\pi(.0048)^2/.00462\pi = \underline{0.19}$$

Comparing the calculated values of the proposed design with the design guidelines of the prior art show that the proposed design for the inner tube of Case D approximately meets the conditions for uniform flow.

The proposed outer tube design for Case D must also be verified against the criteria of Equations 5a and 5b. For Case D, the first relationship is met; that is, $\frac{D_{eff}}{D_{in}}$ =.209/.136 = 1.54 which is well within the required factor of 3. The outer tube of Case D is comprised of 77 holes each having a diameter of 0.0138 inches. Thus, Equation 5b for an outer tube approximately 9.7 inch long becomes, $9.7\pi(.261)/(77 \times .0069^2\pi) = 690$.

Example 3: Case E of Table 1 uses the same inner tube design as Case D but has a set of three narrow slots rather than a linear array of orifices in the outer tube. The relationships for the outer tube with such a set of slots according to the present invention are thus:

$$\frac{D_{eff}}{D_{in}} =.209/.136 = 1.54 \text{ as before}$$

$$\text{Surface area to cross sectional slot area} =$$

$$(9.7)\pi(.261)/(3 \times 3.060 \times .005) = 173$$

and again the criteria for the outer tube are met.

The annular space between the innermost and outermost tubes is an effective annular space. In other words the annular space is the area between the innermost and outermost tubes irrespective of the shape of the tubes since the tubes can be of a variety of shapes (in addition to a cylindrical shape).

As described above and demonstrated by the aforementioned experiments, the gas delivery metering tube of the present invention provides substantially uniform gas flow along a given length, irrespective of diameter size or length, by creating a means to establish constant backing pressure independently from establishing uniform flow along the tube length. As shown, the annular cross sectional volume is important to achieving the desired flow rate and uniformity. Of particular advantage, it is found that the wall size of the tubes is not important in achieving the desired result, provided that the aspect ratio (i.e. the hole-to-wall thickness) is $\geq 1$; nor is the supply gas feed, provided the supply gas feed does not constrict the gas flow.

Of further advantage, the axially aligned, nested tubes can be of different shapes. For example, the nested tubes can be comprised of two axially aligned, rectangular tubes, as opposed to the cylindrical tubes shown in the figures. Moreover, the gas delivery metering tubes of the present invention can be configured to provide the "jetting" type gas flow when desired, or alternatively can be configured for the absence of jetting.

New Embodiment

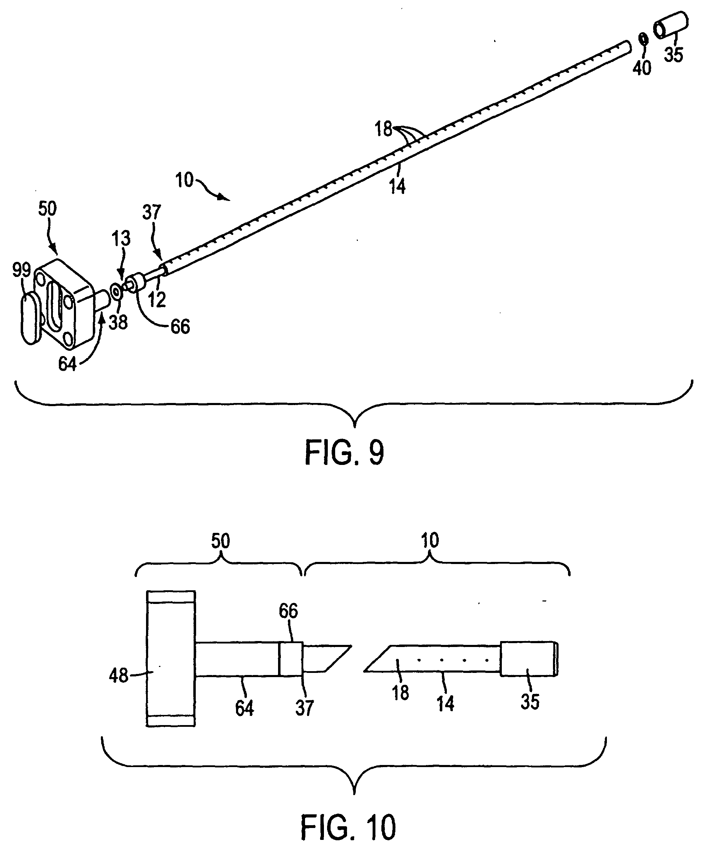

An alternative embodiment of the present invention is illustrated in Figures 9 to 14. Figure 9 is an exploded diagram of a gas delivery metering tube 10 comprising a two-tube assembly having nested, coaxial inner 12 and outer 14 tubes separated by an annular space 15. The outer tube 14 is closed at one end by an end cap 35 while the opposite inlet end 37 of the outer tube is attached to a gas supply port 50. The outer tube 14 contains at least one array of orifices 18 distributed along its substantial length as shown for example in Figures 9 and 10. The inner tube 12 has open inlet 13 and outlet 17 ends, and is nested inside the outer tube 14. The inner tube 12 does not contain an array of orifices.

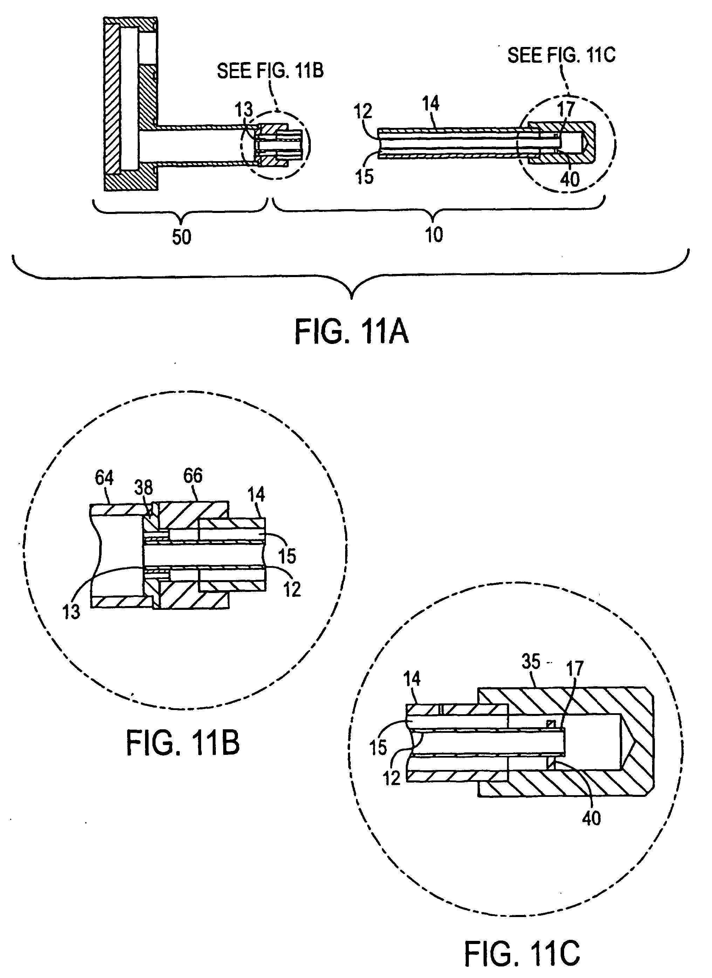

The outlet end 17 of the inner tube 12 does not contact the inner surface of the end cap 35; but rather, as shown in Figures 11a and 11c, it terminates some distance from the end cap 35 so that gas may flow out of the outlet end 17 of the inner tube 12 and into the annular space 15. The exact distance of separation from the outlet end 17 of the inner tube 12 to the inner surface of the end cap 35 is not a crucial parameter in the operation of the metering tube. Distances in the range of approximately 0.1 inch to 0.25 inch are expected to work acceptably. In a specific embodiment of the invention, a separation distance of 0.135 inch was used. This provides an advantage of supplying gas to opposite ends of the gas delivery metering tube 10 while employing only a single gas supply port at only one end.

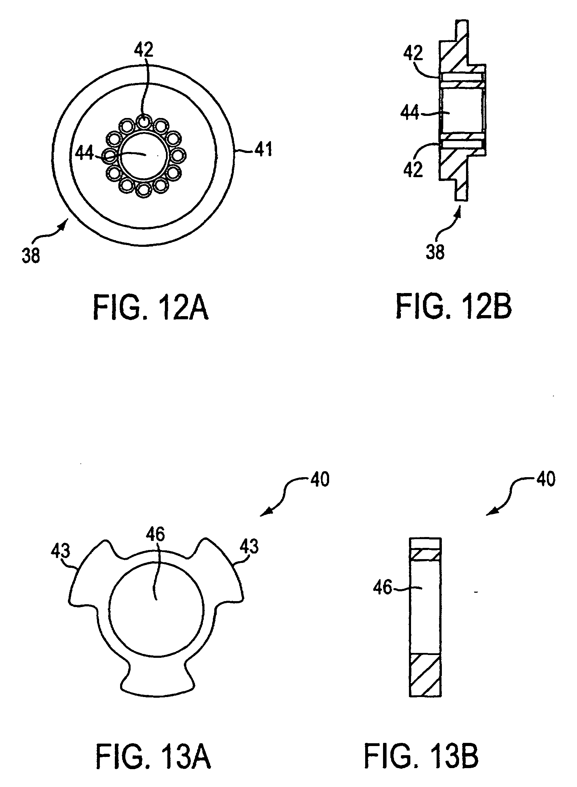

To convey gas to opposite ends of the gas delivery metering tube 10 while using only a single gas supply port 50, the present invention provides a gas flow divider 38 positioned adjacent the inlet ends of the inner and outer tubes. The gas flow divider 38 has a first gas flow path coupled to the inner tube 12 and a second gas flow path coupled to the annular space 15 between the inner and outer tubes. More specifically, the gas flow divider 38 is disposed proximate to the inlet end 37 of the outer tube 14 opposite the end cap 35 and aligned along the transverse axis approximately even with the inlet end 13 of the inner tube 12. The gas flow divider 38, an example of which is shown in Figures 12a and 12b, is comprised of a disk 41 having a plurality of small orifices 42 formed there through and a center orifice 44. The central orifice 44 has diameter approximately equal to the outer diameter of the inner tube 12, and is positioned adjacent the inlet end 13 of the inner tube and along the transverse centerline of the inner tube to provide a first gas flow path into the inner tube 12. The plurality of small orifices 42 are preferably placed around the circumference of the disk 41 and provide a second gas flow path into the annular space 15. Alternatively, the gas flow divider 38 may be formed as a flange on the inlet end 13 of the inner tube 12, and having a lip with the plurality of orifices 42 formed there through. In another alternative embodiment the gas flow divider 38 may be formed as part of the gas supply port 50.

The diameter of the center orifice 44 and the plurality of orifices 42 are not particularly limited; however, preferably, the total sum of the cross sectional area of the plurality of orifices 42 is preferably substantially equivalent to the cross sectional area of the inside of the inner tube 12. Moreover, the plurality of orifices 42 may all have the same diameter, alternatively the diameter of all of the orifices 42 may differ. In one example, the diameter of the orifices 42 are in the range of about 0.015 inch to 0.025 inch and the inner diameter of the inner tube 12 is in the range of about 0.065 inch to 0.075 inch.

The inner tube 12 is supported axially within the outer tube 14, at least in part, by one or more standoff spacers 40. Standoff spacers 40 are provided to axially center the inner tube 12 inside the outer tube 14. One example of a standoff spacer 40 is shown in figures 13a and 13b and is comprised of a thin sheet having one or more standoff portions 43 and a central hole 46. The central hole 46 has a diameter just slightly larger than the outer diameter of the inner tube 12. Inner tube 12 is inserted axially into hole 46 and the standoff portions 43 engage the inner wall of the outer tube. One or more standoff spacers 40 may be positioned along the length of the inner tube. Preferably, one standoff spacer is located adjacent the outlet end 17 of the inner tube. The standoff portions 43 are preferably formed of a shape to substantially minimize obstruction of the annular space 15.

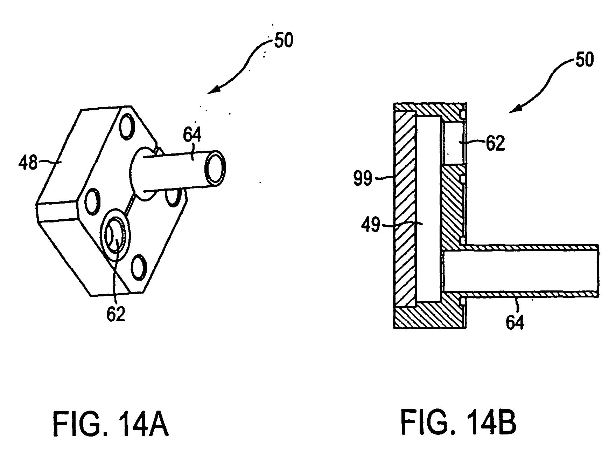

As described above, of particular advantage the present invention provides delivery of gas at opposite ends within the gas delivery metering tube 10 while using only a single gas supply inlet at only one end of the tube 10. Gas is supplied by a single gas supply port 50, shown for example in Figures 14a and 14b. The gas supply port 50 is disposed at one end of the metering tube 10 and is comprised of a single unit block 48 having a hollowed volume or pocket 49 formed therein, gas supply connector 62 and hollow tube stub 64. A cover or cap 99 is welded onto the pocket to enclose the gas path. Attached to gas supply connector 62 is appropriate plumbing (not shown) to convey gas from a gas supply through the pocket 49 and out through the hollow tube assembly 64. The hollow tube stub 64 is coupled to the gas delivery metering tube 10. The outer tube 14 includes the adapter 66 at one end. The adapter 66 joins the outer tube 14 to the larger diameter tube stub 64. In one exemplary embodiment, the flow divider 38 is positioned between the tube stub 64 and the adapter 66, and all three components are welded together. In this embodiment the adapter 66 functions in effect as an extension of outer tube 14 such that substantially no flow disruptions exist as gas travels through the flow divider 38 and into the annular space 15.

During operation, gas is conveyed from the gas supply and into the pocket 49 via the connector 62. Gas travels through the pocket 49, out through the hollow tube stub 64, and into the gas delivery metering tube 10 as shown for example in figures 11a and 11b . As gas approaches the tube 10 it is conveyed through the gas flow divider 38, and is split between the first flow path provided by the center orifice 44 and the second flow path provided by the plurality of small orifices 42. Gas that is divided by the center orifice 44 enters the inner tube 12, and the gas divided by the plurality of small orifices 42 enters the annular space 15. By keeping the cross sectional areas of these two paths about equal, approximately equal volumetric gas flow rates are provided in the two gas flow paths. Because the inner tube 12 has no orifices along its length, the gas exits the inner tube at its outlet end, and enters the annual space 15 at end opposite of the inlet end. In other words, gas from the inner tube enters the annular space 15 at the opposite end of where gas enters the annular space 15 through plurality of orifices 42. Thus, gas is conveyed to both ends of the gas delivery metering tube 10, while employing a single gas supply port connected to only one end of the gas delivery metering tube 10.

In the exemplary embodiment shown in Figs. 9 to 14, the array of orifices 18 in the metering tube are of substantially the same size and spaced equal-distance; however, alternative embodiments may also be used without departing from the scope of the invention. For example, the pitch of the orifices 18 may vary to provide a desired gas flow pattern. In another example, the diameter of the individual orifices may vary in size to tailor the gas flow pattern. The orifices 18 may be formed by any suitable technique. For example the orifices 18 may be formed as pop through holes. Alternatively, the orifices may be formed in a material, preferably a material suitable for close tolerance machining such as ruby, and then such orifice is seated into a pop through hole.

Other features and advantages of the present invention may be apparent to a person of skill in the art who studies the present invention disclosure. The foregoing description of specific embodiments and examples of the invention have been presented for the purpose of illustration and description.

**Claims**

1. A gas delivery metering tube for delivering a gas, comprising:

   an outer tube (14) having an open inlet end (37) and a closed end (35), and an array of orifices (18) formed in said outer tube (14) and extending along the substantial length thereof;
   an inner tube (12) having an open inlet end (13),

   **characterised in that** said inner tube (12) is nested and axially aligned inside said outer tube (14) forming an effective annular space (15) between said tubes,
   the inner tube (12) has an open outlet end (17) which terminates short of the closed end (35) of the outer tube (14),
   and **in that** a gas flow divider construction (38) adjacent the inlet ends (13,37) of the inner and outer tubes (12,14) provides a first gas flow path (44) coupled to said inner tube (12) and a second gas flow path (42) coupled to the annular space (15) between the inner and outer tubes (12,14).

2. A gas delivery metering tube of claim 1 wherein the gas flow divider construction (38) comprises a disk (41) having a central orifice (44) forming said first gas flow path and a plurality of small orifices (42) forming said second gas flow path.

3. A gas delivery metering tube of claim 1 wherein the gas flow divider construction comprises a flange on the inlet end of said inner tube (12), said flange having a lip with a plurality of small orifices forming said second gas flow path.

4. A gas delivery metering tube of claim 2 or 3 wherein the cross-sectional area of the inside of said inner tube (12) is approximately equal to the total cross-sectional area of said plurality of small orifices (42) in said flow divider construction (38).

5. A gas delivery metering tube of any one of the preceding claims comprising a single gas supply port (50) connected via the gas flow divider construction (38) to the inlet ends of both said inner and said outer tube, for supplying gas to the metering tube.

6. A gas delivery metering tube of claim 5 wherein said gas supply port (50) comprises a block (48) having a pocket (49) formed therein, said pocket being sealed with a cover (99) to create a confined passage, a gas supply connector (62) coupled to said pocket for receiving gas and a hollow tube assembly (64) coupled to said pocket (49) and to said inlet ends of the inner and outer tubes (12,14) to convey the gas thereto.

7. A gas metering tube of any one of the preceding claims comprising one or more standoff spacers (40) attached to said inner tube (12) to align the inner tube axially inside said outer tube.

8. A gas metering tube according to any one of the preceding claims in which the inner tube (12) extends from its inlet end (13) to the opposite end of the outer tube's array of orifices (18).

9. A chemical vapour deposition system comprising a gas delivery metering tube according to any one of claims 1 to 8.

10. Chemical vapour deposition system of claim 9 comprising at least one injector assembly having at least one port for receiving said gas delivery metering tube.

11. Chemical vapour deposition system of claim 9 comprising at least one shield assembly having at least one plenum for receiving said gas delivery metering tube.

12. The use of a gas delivery tube as defined in any one of claims 1 to 8 for delivering a gas to a deposition chamber in a process of chemical vapour deposition onto a substrate.

**Patentansprüche**

1. Gasabgabe-Dosierrohr zur Abgabe von Gas, umfassend:

   ein äußeres Rohr (14) mit einem offenen Einlassende (37) und einem verschlossenen Ende (35) und eine Anordnung von Öffnungen (18), die im äußeren Rohr (14) angeordnet sind und sich im Wesentlichen entlang dessen gesamter Länge erstrecken;

   ein inneres Rohr (12) mit einem offenen Einlassende (13), **dadurch gekennzeichnet, dass** das innere Rohr im Inneren des äußeren Rohrs (14) angeordnet und axial ausgerichtet ist, wodurch ein wirksamer ringförmiger Raum (15) zwischen den Rohren ausgebildet ist,

   wobei das innere Rohr (12) ein offenes Austrittsende (17) aufweist, das knapp vor dem verschlossenen Ende (35) des äußeren Rohrs (14) endet,
   und dass eine an die Einlassenden (13, 37) der inneren und äußeren Rohre (12, 14) angrenzende Gasströmungsteilerkonstruktion (38) einen ersten Gasströmungsweg (44), der mit dem inneren Rohr (12) verbunden ist, und einen zweiten Gasströmungsweg (42), der mit dem ringförmigen Raum (15) zwischen dem äußeren und dem inneren Rohr (12, 14) verbunden ist, bereitstellt.

2. Gasabgabe-Dosierrohr nach Anspruch 1, worin die Gasströmungsteilerkonstruktion (38) eine Scheibe (41) mit einer zentralen Öffnung (44), die den ersten Gasströmungsweg bildet, und eine Vielzahl an kleinen Öffnungen (42), die den zweiten Gasströmungsweg bilden, umfasst.

3. Gasabgabe-Dosierrohr nach Anspruch 1, worin die Gasströmungsteilerkonstruktion einen Flansch am Einlassende des inneren Rohrs (12) umfasst, wobei der Flansch einen Rand mit einer Vielzahl an kleinen Öffnungen, die den zweiten Gasströmungsweg bilden, umfasst.

4. Gasabgabe-Dosierrohr nach Anspruch 2 oder 3, worin die Querschnittsfläche des Inneren des inneren Rohrs (12) annähernd gleich der Gesamtquerschnittsfläche der Vielzahl an kleinen Öffnungen (42) in der Gasströmungsteilerkonstruktion (38) ist.

5. Gasabgabe-Dosierrohr nach einem der vorangegangenen Ansprüche, umfassend eine einzige Gasabgabeöffnung (50), die über die Gasströmungsteilerkonstruktion (38) mit den Einlassenden des inneren und des äußeren Rohrs zur Abgabe von Gas an das Dosierrohr verbunden ist.

6. Gasabgabe-Dosierrohr nach Anspruch 5, worin die Gasabgabeöffnung (50) ein Stück (48) mit einer darin ausgebildeten Tasche (49), welche Tasche mit einem Deckel (99) zur Bildung eines eingegrenzten Durchlasses abgedichtet ist, ein Gasabgabe-Anschlussstück (62), das mit der Tasche verbunden ist, um Gas zu erhalten, und eine hohle Rohranordnung (64), die mit der Tasche und mit den Einlassenden des inneren und des äußeren Rohrs (12, 14) zur Förderung von Gas zu diesen verbunden ist, umfasst.

7. Gasabgabe-Dosierrohr nach einem der vorangegangenen Ansprüche, umfassend einen oder mehrere am inneren Rohr (12) angebrachte Abstandshalter (40) zur axialen Ausrichtung des inneren Rohrs im Inneren des äußeren Rohrs.

8. Gasabgabe-Dosierrohr nach einem der vorangegangenen Ansprüche, worin sich das innere Rohr (12) von seinem Einlassende (13) zum gegenüberliegenden Ende der Anordnung von Öffnungen (18) des äußeren Rohrs erstreckt.

9. Chemisches Bedampfungssystem, umfassend ein Gasabgabe-Dosierrohr nach einem der Ansprüche 1 bis 8.

10. Chemisches Bedampfungssystem nach Anspruch 9, umfassend zumindest eine Einspritzanordnung mit zumindest einer Öffnung zum Aufnehmen des Gasabgabe-Dosierrohrs.

11. Chemisches Bedampfungssystem nach Anspruch 9, umfassend zumindest eine Schirmanordnung mit zumindest einer Kammer zum Aufnehmen des Gasabgabe-Dosierrohrs.

12. Verwendung eines Gasabgabe-Dosierrohrs nach einem der Ansprüche 1 bis 8 zur Abgabe von Gas an eine Bedampfungskammer in einem Verfahren zur chemischen Bedampfung eines Substrats.

**Revendications**

1. Tube doseur pour la fourniture de gaz pour fournir du gaz, comprenant:

   un tube externe (14) présentant une extrémité d'entrée ouverte (37) et une extrémité fermée (35), et une rangée d'orifices (18) ménagée dans ledit tube externe (14) et s'étendant sensiblement sur la longueur de celui-ci;
   un tube interne (12) ayant une extrémité d'entrée ouverte (13),

   **caractérisé en ce que** ledit tube interne (12) est emboîté et aligné axialement à l'intérieur dudit tube externe (14) en formant un espace annulaire effectif (15) entre lesdits tubes,
   le tube interne (12) présente une extrémité de sortie ouverte (17) qui se termine peu avant l'extrémité fermée (35) du tube externe (14),
   et **en ce qu'**une construction de division (38) du flux de gaz adjacente aux extrémités d'entrée (13,37) des tubes interne et externe (12,14) fournit un premier chemin d'écoulement de gaz (44) couplé audit tube interne (12) et un second chemin d'écoulement de gaz (42) couplé à l'espace annulaire (15) entre les tubes interne et externe (12,14).

2. Tube doseur pour la fourniture de gaz selon la revendication 1, où la construction de division (38) du flux de gaz comprend un disque (41) présentant un orifice central (44) formant ledit premier chemin d'écoulement de gaz ainsi qu'une pluralité de petits orifices (42) formant ledit second chemin d'écoulement de gaz.

3. Tube doseur pour la fourniture de gaz selon la revendication 1, où la construction de division du flux de gaz comprend une bride sur l'extrémité d'entrée dudit tube interne (12), ladite bride ayant une lèvre avec plusieurs petits orifices formant ledit second chemin d'écoulement de gaz.

4. Tube doseur pour la fourniture de gaz selon la revendication 2 ou 3, où l'aire en section transversale de l'intérieur dudit tube interne (12) est approximativement égale à l'aire totale en section transversale de ladite pluralité de petits orifices (42) dans ladite construction de division (38) du flux.

5. Tube doseur pour la fourniture de gaz selon l'une des revendicatio ns précédentes, comprenant un orifice de fourniture de gaz unique (50) relié par la construction de division (38) du flux de gaz aux extrémités d'entrée à la fois dudit tube interne et dudit tube externe, pour fournir du gaz au tube doseur.

6. Tube doseur pour la fourniture de gaz selon la revendication 5, où ledit orifice de fourniture de gaz (50) comprend un bloc (48) présentant une poche (49) formée dans celui-ci, ladite poche étant scellée avec un couvercle (99) pour créer un passage confiné, un connecteur de fourniture de gaz (62) couplé à ladite poche pour recevoir du gaz ainsi qu'un ensemble formant tube creux (64) couplé à ladite poche (49) et auxdites extrémités d'entrée des tubes interne et externe (12,14) pour convoyer le gaz vers celles-ci.

7. Tube doseur de gaz selon l'une des revendications précédentes, comprenant une ou plusieurs pièces d'écartement saillantes (40) fixées audit tube interne (12) pour aligner le tube interne axialement à l'intérieur dudit tube externe.

8. Tube doseur de gaz selon l'une des revendications précédentes, où le tube interne (12) s'étend de son extrémité d'entrée (13) à l'extrémité opposée de la rangée d'orifices (18) du tube externe.

9. Système chimique de dépôt en phase vapeur, comprenant un tube doseur pour la fourniture du gaz selon l'une des revendications 1 à 8.

10. Système chimique de dépôt en phase vapeur selon la revendication 9, comprenant au moins un ensemble d'injection comportant au moins un orifice pour recevoir ledit tube doseur pour la fourniture de gaz.

11. Système chimique de dépôt en phase vapeur selon la revendication 9, comprenant au moins un ensemble de protection comportant au moins un branchement pour recevoir ledit tube doseur pour la fourniture de gaz.

12. Utilisation d'un tube doseur de gaz tel que défini dans l'une des revendications 1 à 8, pour fournir du gaz à une chambre de dépôt lors d'un processus de dépôt chimique en phase vapeur sur un substrat.

FIG. 1

FIG. 2

**FIG. 3A**

**FIG. 3B**

UNIFORM EXIT SLOT DISTRIBUTION

**FIG. 4**
**(PRIOR ART)**

FIG. 6A

FIG. 5

FIG. 6B

EXTERNAL TUBE
WITH SEVERAL ROWS
OF PORTS AT GIVEN
DISTANCE

INNER TUBE

FIG. 7

FIG. 8

50

99
13
37
10
18
50
40
35
14
12
38
66
64

## FIG. 9

50
10

48
66
64
37
18
14
35

## FIG. 10

SEE FIG. 11B

SEE FIG. 11C

13

12    14    17

15    40

50    10

## FIG. 11A

64    38    66    14

15

13    12

## FIG. 11B

35    17

14

15

12

40

## FIG. 11C

FIG. 12A

FIG. 12B

FIG. 13A

FIG. 13B

FIG. 14A

FIG. 14B